Europäisches Patentamt

(19) European Patent Office

Office européen des brevets

(11) **EP 0 409 733 B1**

(12) **FASCICULE DE BREVET EUROPEEN**

(45) Date de publication et mention
de la délivrance du brevet:
**10.01.1996 Bulletin 1996/02**

(51) Int. Cl.$^6$: **C04B 35/52**, C04B 35/58,
C04B 41/50, C04B 41/52,
C23C 16/36

(21) Numéro de dépôt: **90402081.5**

(22) Date de dépôt: **19.07.1990**

(54) **Matériau carboné protégé contre l'oxydation par du carbonitrure de bore**

Gegen Oxidation durch Borcarbonitride geschütztes kohlenstoffhaltiges Material

Carbonaceous material protected against oxidation by boron carbonitrides

(84) Etats contractants désignés:
**AT BE CH DE DK ES FR GB GR IT LI LU NL SE**

(30) Priorité: **21.07.1989 FR 8909872**

(43) Date de publication de la demande:
**23.01.1991 Bulletin 1991/04**

(73) Titulaire: **AEROSPATIALE Société Nationale
Industrielle
F-75781 Paris Cédex 16 (FR)**

(72) Inventeurs:
• **Grenie, Yves
F-33700 Mérignac (FR)**
• **Marchand, André
F-33700 Mérignac (FR)**

• **Saugnac, Frédéric
F-33400 Talence (FR)**

(74) Mandataire: **Dubois-Chabert, Guy et al
F-75008 Paris (FR)**

(56) Documents cités:
EP-A- 0 282 386          DE-A- 2 600 631
FR-A- 1 222 837          FR-A- 2 075 095

• CHEMICAL ABSTRACTS, vol. 106, No. 24, 15 juin
1987, Columbus, OH (US); R.R. Kamer, p. 307, no.
206603q
• PATENT ABSTRACTS OF JAPAN, vol. 8, No. 102,
(C-222)(1539), 12 mai 1984

## Description

La présente invention se rapporte à des matériaux carbonés rendus inoxydables jusqu'à une température de 2000°C et pendant de longues durées (plusieurs centaines d'heures).

Ces matériaux peuvent être utilisés dans de nombreux secteurs industriels et notamment dans le domaine spatial où ils sont employés comme protection thermique de haute performance pour des véhicules spatiaux réutilisables devant résister aux échauffements provoqués par le frottement de l'air lors de leur rentrée à grande vitesse dans l'atmosphère. Ces véhicules spatiaux sont en particulier ceux dont les missions de rentrée entraînent en des points singuliers plus sollicités que d'autres tels que le nez, les ailerons et les bords d'attaque, des expositions à des températures élevées (de 1800°C sous une pression d'air de 2,8 kPa à 2000°C sous 20 kPa) ou entraînent l'exposition de certaines pièces à des températures variables (de 1000 à 1800°C).

L'invention s'applique aussi à d'autres secteurs industriels nécessitant l'utilisation de pièces capables de résister pendant longtemps (plusieurs centaines d'heures) à des températures variables (600 à 1500°C). Ceci est en particulier le cas des moteurs de turbine à rendement amélioré travaillant à haute température et de certains récupérateurs de chaleur industriels.

Les matériaux carbonés protégés contre l'oxydation auxquels s'applique l'invention sont soit des fibres de carbone disposées de façon à former un substrat fibreux, soit des matériaux composites du type carbone-carbone constitués de manière appropriée de fibres de carbone noyées dans une matrice de carbone, soit des matériaux appelés "massifs" qui ne comportent pas de renfort fibreux.

L'un des avantages essentiels des matériaux carbonés est qu'ils gardent leur intégrité jusqu'à 3000°C, voir plus haut, sous chauffage rapide. En outre, dans le cas des matériaux composites, on note une amélioration des caractéristiques mécaniques de la température ambiante à 1500°C, puis une lente détérioration de ces caractéristiques jusqu'à 2000°C, température à laquelle on retrouve des caractéristiques mécaniques proches de celles du milieu ambiant.

Mais l'inconvénient majeur des matériaux carbonés, simples ou composites, est qu'ils s'oxydent de manière importante dès 400°C en présence d'air.

Pour éviter cette oxydation, différents procédés ont déjà été envisagés concernant la protection des matériaux carbonés basés sur l'utilisation des halogènes et des dérivés halogénés du carbone ou de composés à base de phosphore, de bore, et de silicium.

Le premier brevet relatif à la protection des matériaux carbonés contre l'oxydation date de 1931 ; c'est le brevet US-A-1 948 382. La méthode de protection qui y est décrite est fondée sur un système de revêtement comportant une couche interne en carbure de silicium et une pellicule externe d'anhydride borique. Des verres à base de silice et d'anhydride phosphorique sont également cités dans ce brevet.

Des travaux sur les matériaux du type graphite puis sur les composites carbone-carbone ont alors suivi. Parmi les systèmes de protection contre l'oxydation du carbone cités dans la littérature, ceux qui ont donné lieu à une évaluation quantitative sont le pentaoxyde de phosphore ($P_2O_5$), l'oxyde de bore ($B_2O_3$) et le carbure de silicium (SiC).

Dans le document de P. MAGNE et al. "Etude cinétique de l'oxydation du graphite inhibée par les phosphates", Bull. Soc. Chim. France n°6, (1971), pages 2005-2010, on cite une diminution dans un rapport de 20 de la vitesse d'oxydation du graphite à 600°C dans de l'air sec avec le pentaoxyde de phosphore. Toutefois, cet anhydride réagit avec le carbone vers 1000°C, et cette température limite d'utilisation est encore abaissée dans l'air humide du fait que $P_2O_5$ est très hygroscopique et que l'eau réagit très tôt avec le carbone.

Le document de P. EHRBURGER et al., "Inhibition of the oxydation of carbon-carbon composites by boron oxide", Carbon vol. 24, n° 4, (1986), pages 495-499, enseigne que l'oxyde de bore entraîne à 710°C dans l'air sec une diminution de la vitesse d'oxydation du carbone dans un rapport de 50. Toutefois, cet oxyde commence à se volatiliser de façon appréciable vers 800°C.

Quant au carbure de silicium, très souvent utilisé, on trouve peu d'études fondamentales sur son efficacité dans la littérature. Toutefois, pour un chauffage dans l'air à des températures inférieures à 1500°C, une vitesse d'oxydation du carbone, au moins 100 fois plus faible que celle obtenue en l'absence de SiC, peut être obtenue avec une proportion de SiC introduite dans le matériau, de l'ordre de 30% en volume. Or, les matériaux carbonés usuels, en particulier les matériaux composites carbone-carbone de haute performance, ne permettent pas un tel taux d'incorporation de SiC dans la matrice puisqu'ils ne comportent que 6% à 10% en volume de porosité susceptible d'être remplie par le carbure.

Dans tous les travaux cités précédemment, la protection des matériaux carbonés contre l'oxydation s'obtient essentiellement grâce à la réalisation d'un revêtement vitreux imperméable à l'oxygène ($P_2O_5$, $B_2O_3$). En particulier, le SiC se recouvre d'une pellicule de silice très peu perméable à l'oxygène dès son contact avec l'oxygène de l'air.

Une autre voie explorée pour la protection anti-oxydation du carbone consiste à réduire la réactivité du carbone vis-à-vis de l'oxygène par l'adjonction d'un inhibiteur. On sait depuis longtemps qu'un rôle essentiel dans le mécanisme de l'oxydation des atomes de carbone est joué par des "sites actifs" qui semblent préférentiellement situés sur ce qu'on appelle les "bords" des cristallites graphitiques.

L'occupation de ces sites par des hétéro-atomes ou molécules convenables est de nature à réduire la vitesse d'oxydation du carbone.

L'activité inhibitrice de $P_2O_5$ et de $B_2O_3$ est partiellement due à ce phénomène. Celle du bore a été récemment analysée. Ainsi, Jones et Thrower dans l'article "The effect of boron on carbon fiber microstructure and reactivity", J. Chim. Phys. 84, n°11/12, (1987), pages 1431-1438, ont montré que l'incorporation de bore jusqu'à 5% dans du carbone en réduit appréciablement la réactivité vis-à-vis de l'oxygène.

Cet effet est explicable à la fois par le blocage des sites actifs et par le recouvrement superficiel du carbone par une couche d'oxyde borique imperméable à l'oxygène. Il est en outre suggéré dans cet article que, substitué au carbone et jouant le rôle d'un accepteur d'électrons, le bore peut renforcer la cohésion du réseau carboné vis-à-vis de l'oxygène. Enfin, dès que la teneur du bore dépasse 1% dans le carbone, il cesse de se fixer en substitution et l'excédent apparaît sous forme de carbure de bore.

Comme autre document faisant état de l'incorporation du bore dans les matériaux carbonés pour diminuer leur activité vis-à-vis de l'oxygène chaud, on peut citer le document FR-A-2 569 684 ; ce dernier décrit des protections contre l'oxydation obtenues par dépôt chimique en phase vapeur (DCPV en abréviation) de bore dans des matériaux carbonés pour une utilisation au-dessous de 1200°C. Cette température relativement basse de la limite d'utilisation est destinée à éviter la réaction carbone-bore qui commence au-delà de 1200°C et diminue de ce fait la résistance mécanique des fibres des composites carbone-carbone. Ces matériaux infiltrés par du bore peuvent en outre être recouverts de carbure de silicium.

Les brevets US-A-4 101 354 et US-A-4 164 601 décrivent un procédé applicable aux matériaux composites du type carbone-carbone, qui consiste à protéger les fibres, contre la réaction carbone-bore, par une couche de carbone obtenue à partir de copolymères de l'alcool furfurylique. Les imprégnations suivantes sont faites avec des résines contenant de plus ou moins grandes quantités de bore amorphe et chauffées jusqu'à 2150°C. Ce procédé améliore de façon remarquable les caractéristiques mécaniques des matériaux.

Le brevet US-A-3 672 936 décrit un procédé permettant d'incorporer du bore, du nitrure de bore, du siliciure de bore ou des borures de métaux réfractaires à l'état solide sur des renforts fibreux, avant l'imprégnation par une matière carbonée obtenue à partir d'une résine.

Enfin, le document FR-A-2 556 713 décrit quant à lui un procédé permettant d'incorporer du bore plus ou moins allié à un métal réfractaire (W ou Mo) dans la matrice carbonée.

Pour obtenir une protection à haute température, il est décrit par ailleurs l'utilisation d'une céramique sur la surface externe du matériau carboné. SiC et $Si_3N_4$ sont les céramiques les plus appropriées car elles sont réfractaires et compatibles avec le carbone. En outre, leurs coefficients de dilatation sont parmi les plus proches de ceux des matériaux carbonés.

Cette dernière propriété n'empêche cependant pas, notamment dans le cas des matériaux composites carbone-carbone de hautes performances, l'apparition de craquelures dans le revêtement de céramique ; l'oxygène chaud peut alors atteindre le matériau carboné, et provoquer sa destruction.

Plusieurs solutions ont été proposées pour combler ces fissures. Dans la majorité des cas elles font intervenir des verres à base de bore et de silice.

En particulier, le brevet US-A-4 613 522 décrit un procédé qui permet de réaliser un matériau composite carbone-carbone dont la matrice de densification est obtenue avec une résine comportant du bore ou du carbure de bore, l'extérieur de la pièce étant recouvert d'une couche de carbure de silicium. Par chauffage en atmosphère oxydante, il se forme un verre borosilicaté qui bouche les craquelures du carbure de silicium.

Dans le brevet US-A-4 668 579, le principe de protection est le même que précédemment, mais le carbure de bore est obtenu par dépôt chimique en phase vapeur.

Le document FR-A-2 611 198 déposé au nom du demandeur décrit une protection contre l'oxydation des composites carbone-carbone par recouvrement des fibres et infiltration de la matrice avec du carbure de silicium et par création à la surface de la pièce d'une pellicule de SiC rendue étanche par un verre borosilicaté.

Le document FR-A-2 075 095 décrit la possibilité d'envelopper une matière carbonée par une couche de carbonitrure de bore.

Malheureusement, les verres contenant de l'oxyde de bore peuvent être hygroscopiques, ou poser (du fait de la présence d'oxygène) des problèmes de compatibilité chimique avec le carbone et/ou la couche extérieure en SiC. Ceci limite la durée de vie du matériau pour des expositions de longue durée en ambiance oxydante et/ou humide.

L'invention a justement pour objet un matériau carboné protégé contre l'oxydation permettant de remédier aux différents inconvénients donnés ci-dessus. En particulier elle permet l'obtention d'une meilleure protection des matériaux carbonés sur une large gamme de températures, pouvant aller jusqu'à 2000°C, et ce, pendant de longues durées, là où les techniques antérieures connues se révèlent insuffisantes.

Ce résultat est obtenu en utilisant simultanément les deux voies de protection connues qui sont la création d'une couche superficielle imperméable à l'oxygène et la diminution de la réactivité du carbone vis-à-vis de l'oxygène.

L'invention repose sur la mise en oeuvre d'un nouveau matériau réfractaire à base de bore, d'azote, et de carbone qui peut être infiltré dans le matériau carboné à protéger et/ou déposé en couches superficielles.

Ce matériau réfractaire constitue une véritable solution solide carbone-bore-azote de composition variable. Cette solution solide sera appelée ultérieurement sous le nom de "carbonitrure de bore".

Cette solution solide peut avoir des compositions variables, allant du carbone presque pur au nitrure de bore presque pur, selon les conditions de préparation et selon le type de protection recherché. En outre, des gradients de concentration de ces divers constituants peuvent être réalisés à l'intérieur d'un même matériau carboné. De plus, le carbonitrure de bore peut s'allier à l'oxygène, pouvant améliorer ses propriétés de protection.

De façon plus précise, l'invention a pour objet un matériau carboné protégé de l'oxydation par du carbonitrure de bore contenant en % d'atomes :

- de 0 à 30% d'oxygène,
- de 1 à 98% de carbone,
- de 1 à 98% de bore, et
- de 1 à 98% d'azote, avec un rapport atomique B/N plus grand ou égal à 1 et comportant au moins une couche extérieure en céramique recouvrant le revêtement en carbonitrure de bore.

En particulier, le carbonitrure de bore peut contenir en % d'atomes :

- 0 à 25% d'oxygène,
- 5 à 85% de carbone,
- 10 à 50% de bore, et
- 5 à 50% d'azote.

Suivant les conditions opératoires, de préférence, le carbonitrure de bore présente la formule suivante : $C_{0,64} B_{0,24} N_{0,12}$ ou la formule suivante : $C_{0,30} B_{0,35} N_{0,35}$.

Le carbonitrure de bore est noté ci-après CBN lorsqu'il ne contient pas d'oxygène et CBNO lorsqu'il contient de l'oxygène. L'introduction de l'oxygène peut avoir lieu lors de l'élaboration du matériau ou bien lors de son utilisation en présence d'oxygène.

Le CBN ou CBNO est particulièrement adapté à la protection des matériaux carbonés contre l'oxydation. Le CBN en particulier est réfractaire et peut résister sans dommage à des températures d'au moins 1700°C sous atmosphère neutre.

Par ailleurs, la composition atomique en carbone, bore, azote et oxygène peut être adaptée aux besoins. En effet, il suffit de faire varier ses conditions de fabrication et en particulier la température, la pression et la composition des gaz nécessaires à sa synthèse pour obtenir, au cours d'une même opération, les variations de composition souhaitées.

En outre, le CBN ou CBNO est compatible chimiquement avec le carbone. En particulier le CBN ne réagit pas avec le carbone jusqu'aux environs de 1900°C. Enfin, les propriétés physiques du CBN ou du CBNO peuvent être ajustées aisément de façon à les rendre compatibles avec celles des matériaux adjacents entrant dans la structure du matériau carboné tels que les céramiques externes (nitrure, siliciure, carbure, borure et oxyde) et les carbones graphités ou non. En effet, la structure du CBN ou du CBNO est essentiellement celle du nitrure de bore et des carbones.

On rappelle en particulier que le nitrure de bore présente une forme cristalline hexagonale dont la maille élémentaire est presque identique à celle du graphite. En outre, les coefficients de dilatation du nitrure de bore hexagonal et du graphite sont très voisins.

De plus, les réseaux cristallins du nitrure de bore et du graphite ont une excellente compatibilité de comportement à toutes températures. En particulier, on obtient une quasi-parfaite épitaxie du réseau de nitrure de bore sur celui du carbone conduisant ainsi à une forte adhérence du nitrure de bore sur du carbone et ce, quels que soient les traitements thermiques. Ces compatibilités cristallines du carbone et du nitrure de bore sont conservées même lorsque le nitrure de bore est "turbostratique".

Le coefficient de dilatation du carbonitrure de bore peut varier de $1.10^{-6}$/K à $36.10^{-6}$/K selon l'orientation des cristallites du matériau, couvrant ainsi largement des différences de comportement des matériaux carbonés et des céramiques. En particulier, si le carbonitrure de bore doit être recouvert d'une couche extérieure de céramique telle qu'une couche de SiC ou de $Si_3N_4$, son coefficient de dilatation est capable de s'adapter aussi bien à celui du matériau carboné qu'à celui de la céramique.

Cette adaptation du coefficient de dilatation du CBN ou du CBNO à celui de la céramique entraîne rarement l'apparition de craquelures dans la couche de céramique extérieure, à l'inverse de ce qui se passe dans l'art antérieur. Toutefois, si cela se produisait, l'oxygène s'arrêterait à la surface du carbonitrure de bore en formant du CBNO et essentiellement de l'oxyde de bore ($B_2O_3$) à sa surface.

Lorsque la céramique externe utilisée s'oxyde en surface, ce qui est notamment le cas des composés contenant du silicium tels que SiC, la mise en contact de l'oxyde de bore et de l'oxyde issu de la céramique comme par exemple la silice, produit un verre, en particulier borosilicaté, cicatrisant les craquelures de la couche de céramique (SiC par exemple).

Le comportement du CBN (exempt d'oxygène) en présence d'oxygène chaud, dépend très étroitement de sa composition et de sa structure cristalline. Il ne subit qu'une variation de masse négligeable par chauffage jusqu'à 900°C, une partie du bore qu'il contient se transformant en oxyde, non volatil dans ces conditions, ce qui compense la perte due à l'oxydation partielle du carbone.

Par ailleurs, l'oxygène a tendance à se fixer et à rester à l'intérieur de la structure du CBN plutôt que de la détruire.

Aussi, le matériau carboné de l'invention peut être protégé de l'oxydation par du carbonitrure contenant en % d'atomes :

- de 5 à 25% d'oxygène,
- de 5 à 80% de carbone,
- de 10 à 50% de bore, et
- de 5 à 50% d'azote.

L'incorporation d'oxygène dans le CBN modifie bien entendu ces propriétés, mais tout l'oxygène, en cas de besoin, peut être éliminé par simple chauffage en atmosphère inerte vers 1700°C.

Le carbonitrure de bore de l'invention peut être fabriqué à partir de 700°C, par DCPV, avec un mélange d'hydrocarbures approprié, de trichlorure de bore et d'ammoniac, dilué dans un gaz porteur tel que l'azote ou l'hydrogène, sous une pression de quelques centaines à quelques milliers de pascals.

Comme hydrocarbures plus ou moins substitués utilisables dans l'invention, on peut citer les hydrocarbures chlorés tels que $CHCl_3$ et $CCl_4$ et des hydrocarbures nitrés. On peut aussi utiliser un hydrocarbure non substitué tel que l'acétylène.

La température et la pression optimales utilisées pour le dépôt en phase vapeur de carbonitrure de bore doivent être adaptées en fonction de l'hydrocarbure utilisé. Par ailleurs, si la température de fabrication croît, la quantité de carbone augmente dans le CBN ou CBNO.

La dilution du mélange gazeux par l'hydrogène, bien que non nécessaire, améliore le rendement de l'opération. En outre, l'hydrogène change par rapport à l'azote, le mécanisme réactionnel mis en jeu en phase gazeuse conduisant à des produits de même composition plus structurés (plus cristallisés) et non hygroscopiques ; ils sont ainsi plus stables thermiquement et peuvent tenir jusqu'à 2000°C.

Comme on l'a dit précédemment, la composition du carbonitrure de bore de l'invention peut être modifiée en fonction des propriétés recherchées et en particulier des propriétés de compatibilité avec les matériaux destinés à être en contact avec lui. En fonction de cette composition, la structure ou l'agencement des différents atomes du carbonitrure de bore obtenu par DCPV varie. Il convient de distinguer les produits contenant plus de 60% d'atomes de carbone et les produits contenant moins de 40% d'atomes de carbone.

En particulier, les composés riches en carbone présentent une structure cristalline alors que les composés contenant moins de 40% d'atomes de carbone sont amorphes. On peut améliorer la cristallinité de ces derniers par un recuit à 1700°C sous atmosphère inerte.

Le rapport B/N est $\geq 1$ et plus précisément compris dans l'intervalle allant de 1,01 à 2.

La composition du carbonitrure de bore réalisé sur ou dans le carbone peut être ajustée en modifiant les conditions de DCPV. On peut en particulier faire varier de manière continue cette composition de façon à obtenir un gradient de concentration du carbone, du bore et/ou de l'azote. Une transition progressive du carbone pur au nitrure de bore pur peut même être réalisée.

Le carbonitrure de bore conformément à l'invention peut être utilisé comme revêtement externe du matériau carboné ou bien être incorporé à ce dernier.

Il peut être employé de plusieurs manières : soit en l'incorporant au matériau carboné (carbone, graphite, fibre de carbone), soit en le déposant sur le matériau carboné par exemple par une transition progressive de composition allant du carbone pur au carbonitrure. La couche extérieure de céramique protectrice est SiC ou $Si_3N_4$ par exemple. Les cas d'utilisation précédents ne sont pas exclusifs les uns des autres.

Plus spécialement, le matériau carboné de l'invention protégé contre l'oxydation est un matériau composite comportant un substrat fibreux ou non en carbone ou en matériau réfractaire noyé ou non dans une matrice carbonée. La matrice peut être en carbone pyrolytique, en carbone graphitique ou en carbone vitreux et renfermer éventuellement de 2 à 10% en poids de SiC.

Les matériaux composites carbone-carbonitrure de bore protégés contre l'oxydation par le CBN peuvent se classer en deux catégories : des matériaux dont la température d'utilisation en atmosphère oxydante ne dépasse pas 900°C et des matériaux dont la température d'utilisation en atmosphère oxydante peut aller jusqu'à 2000°C avec des temps d'exposition à cette atmosphère qui peuvent aller jusqu'à plusieurs centaines d'heures.

Les matériaux de la première catégorie sont réalisés soit avec une matrice mixte carbone-CBN ou carbone-CBNO sous la forme de mélanges ou de solutions solides de carbone et de carbonitrure de bore soit, avec une matrice CBN ou CBNO infiltrée soit avec un dépôt de CBN ou CBNO sur des matériaux carbonés, le CBN ou CBNO ayant une composition variable. Dans ces conditions, la protection contre l'oxydation résulte du blocage des sites actifs du carbone et de la formation d'un film protecteur d'oxyde de bore et/ou de CBNO.

Les matériaux de la seconde catégorie peuvent être réalisés en recouvrant un matériau composite à base de fibres de carbone noyées dans une matrice de carbone ou tout autre matériau composite, d'un revêtement externe de CBN ou de CBNO (avec un éventuel gradient de concentration) et d'une couche extérieure en céramique (SiC, $Si_3N_4$, $Al_2O_3$ ou $ZrO_2$ par exemple).

Dans ces conditions, le carbonitrure de bore bloque les sites actifs du carbone et assure une bonne interface entre le carbone et la céramique, tout en évitant les craquelures de la couche de céramique. L'étanchéité de la céramique empêche la pénétration de l'oxygène dans le matériau carboné.

Le carbonitrure de bore garantit, par rapport à l'art antérieur, une sécurité accrue dans le cas d'un endommagement de la céramique, en permettant la formation d'un film protecteur d'oxyde de bore et/ou de CBNO au sein du matériau. De plus, lors de l'utilisation de SiC comme couche extérieure de céramique, l'oxyde de bore peut s'allier à l'oxyde de silicium obtenu à haute température par oxydation du SiC pour donner un verre "cicatrisant", comblant les éventuelles craquelures de la céramique.

Selon l'invention, le revêtement extérieur en céramique peut également être un revêtement bicouche.

Lorsque l'on utilise de la silice comme céramique extérieure, celle-ci est située à l'extérieur de la pièce ou matériau carboné et est précédée d'une première couche telle que BN, TiN, $MoSi_2$, $TiB_2$, $ZrB_2$ ou $HfB_2$ jouant le rôle de barrière.

Lorsque l'on utilise comme céramique extérieure un oxyde tel que l'alumine, la zircone (stabilisée), $HfO_2$ (stabilisé), ou un spinelle du type $Al_2O_3$-MgO-$Y_2O_3$, cet oxyde est situé à l'extérieur de la pièce et peut recouvrir une première couche choisie parmi les composés tels que BN, AIN, $MoSi_2$, TiN, HfN, $W_2C$, WC, TaC, ZrC, HfC, $TiB_2$, $ZrB_2$, SiC ou $Si_3N_4$, cette première couche jouant le rôle de couche barrière.

Il est aussi possible de réaliser une matrice mixte carbone-CBN ou carbone-CBNO, recouverte d'un revêtement externe de CBN ou CBNO, ce dernier étant recouvert d'un revêtement extérieur en céramique monocouche ou bicouche.

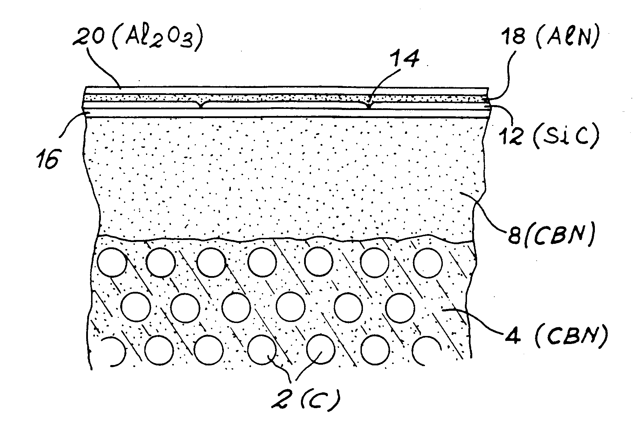

D'autres caractéristiques et avantages de l'invention ressortiront mieux de la description qui va suivre, donnée à titre illustratif et non limitatif en référence à l'unique figure annexée, représentant schématiquement un exemple de réalisation d'un matériau carboné protégé contre l'oxydation conformément à l'invention.

Sur cette figure, le matériau carboné protégé contre l'oxydation conformément à l'invention est un matériau composite du type carbone-carbone comportant des fibres de renforcement 2 en carbone, noyées dans une matrice en carbone pyrolytique. Après densification de la matrice en carbone, on infiltre du CBN dans la matrice en carbone par DCPV, entraînant la formation d'une matrice 4 de CBN à forte teneur en carbone. Les gaz utilisés pour cette infiltration sont du $BCl_3$, du $NH_3$ et du $C_2H_2$ et le gaz porteur de l'azote. La température d'infiltration est $\geq 800°C$.

Dans des conditions similaires, on dépose ensuite une couche externe 8 en CBN, contenant environ 1/3 de carbone, 1/3 d'azote et 1/3 de bore, sur une épaisseur de 10 à 500 micromètres suivant le temps de dépôt. Dans le cas d'une utilisation au-delà de 900°C du matériau carboné, on forme par DCPV une couche extérieure 12 de carbure de silicium par décomposition d'un ou plusieurs organosilanes substitués ou non par un halogène auquel on associe éventuellement un ou plusieurs hydrocarbures gazeux et/ou de l'hydrogène.

Les organosilanes utilisables sont en particulier les chlorosilanes de forme $(CH_3)_nSiCl_{4-n}$ avec $0<n<4$ : on peut par exemple citer le citer le trichlorométhylsilane, le tétraméthylsilane et le dichlorodiméthylsilane.

Les hydrocarbures utilisables sont en particulier le méthane, l'éthane, le propane et le butane.

On utilise de préférence le mélange gazeux contenant de l'hydrogène et du trichlorométhylsilane dans un rapport de 4 à 12. D'autres mélanges peuvent toutefois être utilisés, tels le trichlorométhylsilane en présence d'hydrogène (rapport voisin de 1) et de butane (rapport butane/trichlorométhylsilane de 1 à 5), ou encore le trichlorométhylsilane seul.

Les températures de préparation (600 à 1000°C) et les pressions (5 à 100 hPa) sont fixées de façon à permettre un dépôt régulier. L'épaisseur de SiC peut varier de 2 à 10 micromètres.

Dans certains cas, il est possible d'observer la formation de craquelures 14 à la surface de la couche extérieure en SiC lors de l'utilisation de ce matériau, craquelures dues aux différents coefficients de dilatation. Aussi, dès l'utilisation de ce matériau en atmosphère oxydante, ces craquelures 14 laissent pénétrer de l'oxygène à l'intérieur du matériau protégé, entraînant ainsi la formation d'oxyde de bore qui mouille correctement le SiC et permet la formation d'un verre cicatrisant 16, empêchant toute pénétration ultérieure de l'oxygène à l'intérieur du CBN.

En vue d'utiliser le matériau ci-dessus à des températures supérieures à 1700°C sous atmosphère oxydante à basse pression (typiquement au-dessous de 33 kPa), il est nécessaire de recouvrir la couche 12 de SiC d'un revêtement externe bicouche.

Ce revêtement bicouche comporte par exemple une couche 18 de nitrure d'aluminium, de disiliciure de molybdène ou de nitrure d'hafnium, de 300 à 5000 nm d'épaisseur, recouverte d'une couche 20 d'alumine de 2 à 100 micromètres d'épaisseur.

Le dépôt d'une couche 18 en AIN est réalisé par DCPV sous pression réduite (0,5 à 10 kPa) et/ou sous balayage d'un gaz neutre. Ce dépôt se fait par décomposition d'un mélange de chlorure d'aluminium, d'hydrogène et d'ammoniac.

La couche externe 20 d'alumine est aussi déposée par DCPV selon les réactions chimiques suivantes :

- $$3CO_2 + 3H_2 \text{------>} 3CO + 3H_2O,$$

$$2AlCl_3 + 3H_2O \text{ ------> } Al_2O_3 + 6\ HCl.$$

Les paramètres de mise en oeuvre doivent être réglés précisément de façon à obtenir un revêtement très uniforme et bien adhérent. On utilise par exemple les conditions opératoires suivantes :

- Pression totale 4 kPa,
- Pression de chlorure d'aluminium 0,1 kPa,
- Température 1000°C.

L'épaisseur de la couche d'alumine déposée varie de 2 à 100 micromètres selon les conditions d'utilisation.

Bien que l'invention soit tout à fait bien adaptée à la protection de matériaux composites du type carbone-carbone, l'invention s'applique à tous matériaux carbonés. En particulier, elle peut s'appliquer à un matériau à base de carbone et de carbure de silicium composite ou non ou bien à base de fibres de carbone.

EXEMPLE 1

Cet exemple est relatif à la fabrication d'un film de CBNO contenant moins de 30% d'atomes de carbone déposé à la surface d'un matériau carboné, par DCPV dans les conditions opératoires suivantes :

- Pression : 2,4 kPa,
- Température : 800°C,
- Débit $BCl_3$ : 1,35 litre/heure,
- Débit $NH_3$ : 1,2 litre/heure,
- Débit $C_2H_2$ : 1,2 litre/heure,
- Débit $N_2$ : 1,2 litre/heure,
- Vitesse du mélange de gaz : 16 centimètres/seconde dans le réacteur.

Au bout de 3 heures 15 de dépôt, on a obtenu un film de 150 micromètres d'épaisseur pesant 262 milligrammes. La composition du produit obtenu en % d'atomes est la suivante.

- Bore 35%,
- Azote 31%,
- Carbone 9%,
- Oxygène 25%.

EXEMPLE 2

Pour effectuer une infiltration de carbonitrure de bore à l'intérieur d'un matériau en carbone, on utilise des conditions similaires à celles données dans l'exemple 1.

EXEMPLE 3

Pour obtenir un carbonitrure de bore contenant environ 1/3 de carbore, 1/3 d'azote et 1/3 de bore et en particulier une solution solide de formule $C_{0,30}B_{0,35}N_{0,35}$, déposé à la surface d'un matériau carboné ou infiltré dans ce matériau, on utilise les conditions opératoires de DCPV suivantes :

- Température comprise entre 850°C et 900°C,
- Pression totale de l'ordre de 1,4 kPa,
- Rapport $BCl_3/NH_3$ compris dans l'invervalle de 1,1 à 2,
- Rapport $C_2H_2/NH_3$ égal ou supérieur à 1,
- Rapport $N_2/C_2H_2$ compris entre 0 et 1.

Le produit obtenu contient de l'oxygène après une exposition à l'air pendant un certain temps. On peut éliminer cet oxygène en effectuant un chauffage du produit obtenu vers 1700°C en atmosphère inerte.

EXEMPLE 4

Pour obtenir du CBN (exempt d'oxygène) en dépôt mince en surface d'un matériau carboné ou infiltré, autour de la composition 1/3 de carbone, 1/3 d'azote, 1/3 de bore, on fait varier les proportions des gaz dans les limites de l'exemple 3 et on dilue les gaz dans l'hydrogène et non plus dans l'azote. A cette condition, la température de dépôt peut être augmentée de 900°C à plus de 1000°C.

Les produits ainsi obtenus contiennent toujours un excès de bore par rapport à l'azote (rapport B/N compris dans l'intervalle 1,01-1,3) et peuvent ainsi contenir de 10 à 40% de carbone suivant les conditions opératoires employées. Après deux mois d'exposition à l'air, les produits obtenus ne contiennent pas d'oxygène.

EXEMPLE 5

Pour obtenir un carbonitrure contenant plus de 70% d'atomes de carbone, on utilise les conditions opératoires suivantes :

- Température de l'ordre de 1000°C,
- Pression totale comprise entre 1,4 kPa et 2,8 kPa,
- Rapport $BCl_3/NH_3$ voisin de 1,1,
- Rapport $C_2H_2/NH_3$ voisin de 1,
- Rapport $N_2/C_2H_2$ compris entre 0 et 1.

Le dépôt de carbonitrure de bore obtenu contient de l'oxygène après une exposition à l'air ; on peut effectuer un chauffage du produit obtenu vers 1700°C, en atmosphère d'argon ou d'azote afin d'éliminer l'oxygène présent dans le matériau.

EXEMPLE 6

Pour obtenir un CBN (exempt d'oxygène) contenant environ 64% de C, 24% de B et 12% de N déposé en surface et/ou infiltré dans un matériau poreux carboné, les conditions doivent respecter les règles suivantes :

- Température comprise entre 1000°C et 1100°C,
- Pression totale de 1,8 KPa,
- Rapport $BCl_3/C_2H_2$ supérieur à 1,2,
- Rapport $C_2H_2/NH_3$ supérieur à 2,
- Débit $BCl_3$, 1 l/h,
- Débit $C_2H_2$, 0,6 l/h,
- Dilution gaz dans l'hydrogène dans une proportion supérieure à 8.

La vitesse des gaz dans le réacteur doit être de l'ordre du mètre par seconde.

Au bout de 6 heures de dépôt, on obtient un film mince d'aspect métallique de 50 micromètres environ d'épaisseur correspondant à la formule $C_5B_2N$ ou $C_6B_2N$ suivant les conditions opératoires.

Après deux mois d'exposition à l'air, ce produit n'a pas incorporé d'oxygène.

**Revendications**

1. Matériau carboné protégé contre l'oxydation comprenant un revêtement externe en carbonitrure (4, 8) de bore et au moins une couche extérieure en céramique (12) recouvrant ce revêtement externe, ce revêtement externe étant une solution solide contenant en % d'atomes :

   - de 0 à 30% d'oxygène,
   - de 1 à 98% de carbone,
   - de 1 à 98% de bore, et
   - de 1 à 98% d'azote.

   avec un rapport atomique B/N plus grand ou égal à 1.

2. Matériau selon la revendication 1, caractérisé en ce que le carbonitrure contient en % d'atomes :

   - de 0 à 25% d'oxygène,
   - de 5 à 85% de carbone,
   - de 10 à 50% de bore, et
   - de 5 à 50% d'azote.

3. Matériau selon la revendication 1 ou 2, caractérisé en ce que le carbonitrure de bore contient en % d'atomes :

   - de 5 à 25% d'oxygène,
   - de 5 à 80% de carbone,
   - de 10 à 50% de bore, et
   - de 5 à 50% d'azote.

4. Matériau selon l'une quelconque des revendications 1 à 3, caractérisé en ce que le rapport atomique B/N est dans l'intervalle allant de 1 à 2.

5. Matériau selon la revendication 1, caractérisé en ce que le carbonitrure de bore contient en % d'atomes :

   - de 0 à 25% d'oxygène,
   - de 9 à 66% de carbone,
   - de 22 à 35% de bore, et
   - de 11 à 35% d'azote.

6. Matériau selon la revendication 1, caractérisé en ce que le carbonitrure de bore présente la formule :

$$C_{0,30}B_{0,35}N_{0,35}.$$

7. Matériau selon la revendication 1, caractérisé en ce que le carbonitrure de bore présente la formule : $C_{0,64} B_{0,24} N_{0,12}$.

8. Matériau selon la revendication 1, caractérisé en ce que le carbonitrure de bore répond à la formule $C_6B_2N$.

9. Matériau selon la revendication 1, caractérisé en ce que le carbonitrure de bore répond à la formule $C_5B_2N$.

10. Matériau selon l'une quelconque des revendications 1 á 9, caractérisé en ce que la couche extérieure on céramique (12) est du nitrure ou du carbure de silicium.

11. Matériau selon l'une quelconque des revendications 1 á 10, caractérisé en ce qu'une couche protectrice et/ou de verre cicatrisant (16) est interposée entre le revêtement externe (8) et la couche extérieure en céramique (12).

12. Matériau selon l'une quelconque des revendications 1 à 11, caractérisé en ce que le revêtement externe (8) de carbonitrure de bore est recouvert d'un revêtement extérieur bicouche en céramique (18, 20).

13. Matériau selon la revendication 12, caractérisé en ce que le revêtement extérieur bicouche (18, 20) est constitué d'une couche barrière en nitrure, carbure, borure ou siliciure recouverte d'une couche externe d'oxyde.

14. Matériau selon l'une quelconque des revendications 1 à 6, caractérisé en ce que la couche extérieure en céramique (12) sur le revêtement externe en carbonitrure de bore (8), est revêtue d'une couche barrière en nitrure, carbure, borure ou siliciure (18) puis d'une couche externe (20) d'oxyde.

15. Matériau selon la revendication 13 ou 14, caractérisé en ce que la couche externe d'oxyde (20) est en un matériau choisi parmi l'alumine, la zircone, l'oxyde d'hafnium ($HfO_2$) et un spinelle du type $Al_2O_3$-MgO-$Y_2O_3$.

16. Matériau composite carboné protégé contre l'oxydation selon l'une quelconque des revendications 1 à 15 comportant un substrat carboné caractérisé en ce que ce substrat est infiltré par du carbonitrure de bore.

17. Matériau composite carboné protégé contre l'oxydation selon l'une quelconque des revendications 1 à 15, comportant un substrat de fibres (2) de carbone noyé dans une matrice carbonée (4), caractérisé en ce que la matrice renferme du carbonitrure de bore.

18. Matériau selon l'une quelconque des revendication 1 à 17, caractérisé en ce que le revêtement externe en carbonitrure est obtenu par dépôt chimique en phase vapeur en utilisant un mélange de trichlorure de bore, d'ammoniac et d'hydrocarbure dilué dans de l'hydrogène.

19. Matériau selon la revendication 18, caractérisé en ce que le rapport trichlorure de bore/ammoniac est $\geq 1,1$.

20. Matériau selon la revendication 18 ou 19, caractérisé en ce que le dépôt du carbonitrure de bore est effectué à une température supérieure à 700°C.

21. Matériau selon l'une quelconque des revendications 18 à 20, caractérisé en ce que le dépôt de carbonitrure de bore est effectué à une température comprise entre 1000°C et 1100°C.

22. Matériau selon l'une quelconque des revendications 18 à 21, caractérisé en ce que l'hydrocarbure est l'acétylène.

**Claims**

1. Carbonaceous material protected against oxygen by an outer boron carbonitride coating (4, 8) and at least one outer ceramic layer (12) covering said outer coating, the latter being a solid solution containing in atomic %:

   - 0 to 30% oxygen,
   - 1 to 98% carbon,
   - 1 to 98% boron and
   - 1 to 98% nitrogen,

     with a B/N atomic ratio equal to or greater than 1.

2. Material according to claim 1, characterized in that the carbonitride contains in atomic %:

   - 0 to 25% oxygen,
   - 5 to 85% carbon,
   - 10 to 50% boron and
   - 5 to 50% nitrogen,

3. Material according to claim 1 or 2, characterized in that the boron carbonitride contains in atomic %:

   - 5 to 25% oxygen,
   - 5 to 80% carbon,
   - 10 to 50% boron and
   - 5 to 50% nitrogen.

4. Material according to any one of the claims 1 to 3, characterized in that the B/N atomic ratio is in the range 1 to 2.

5. Material according to claim 1, characterized in that the boron carbonitride contains in atomic %:

   - 0 to 25% oxygen,
   - 9 to 66% carbon,
   - 22 to 35% boron and
   - 11 to 35% nitrogen.

6. Material according to claim 1, characterized in that the boron carbonitride has the following formula:

$$C_{0.30}B_{0.35}N_{0.35}.$$

7. Material according to claim 1, characterized in that the boron carbonitride has the formula $C_{0.64}B_{0.24}N_{0.12}$.

8. Material according to claim 1, characterized in that the boron carbonitride complies with the formula $C_6B_2N$.

9. Material according to claim 1. characterized in that the boron carbonitride complies with the formula $C_5B_2N$.

10. Material according to any one of the claims 1 to 9, characterized in that the outer ceramic coating (12) is silicon carbide or nitride.

11. Material according to any one of the claims 1 to 10, characterized in that a protective coating and/or healing glass (16) is interposed between the outer coating (8) and the outer ceramic layer (12).

12. Material according to any one of the claims 1 to 11, characterized in that the outer boron carbonitride layer (8) is covered with an outer two-layer ceramic coating (18, 20).

13. Material according to claim 12, characterized in that the outer two-layer coating (18, 20) is constituted by a barrier layer of nitride, carbide, boride or silicide covered by an outer oxide layer.

14. Material according to any one of the claims 1 to 6, characterized in that the outer ceramic layer (12) on the outer boron carbonitride layer (8) is covered with a barrier layer of nitride, carbide, boride or silicide (18) and then an outer oxide layer (20).

15. Material according to claim 13 or 14, characterized in that the outer oxide layer (20) is a material chosen from among alumina, zirconia, hafnium dioxide ($HfO_2$) and a spinel of type $Al_2O_3$-$MgO$-$Y_2O_3$.

16. Carbonaceous composite material protected against oxidation according to any one of the claims 1 to 15 comprising a carbonaceous substrate, characterized in that said substrate is infiltrated by boron carbonitride.

17. Carbonaceous composite material protected against oxidation according to any one of the claims 1 to 15 comprising a carbon fibre substrate (2) embedded in a carbonaceous matrix (4), characterized in that the matrix contains boron carbonitride.

18. Material according to any one of the claims 1 to 17, characterized in that the outer carbonitride coating is obtained by vapour phase deposition using a mixture of boron trichloride, ammonia and hydrocarbon diluted in hydrogen.

19. Material according to claim 18, characterized in that the boron trichloride/ammonia ratio is $\geq 1.1$.

20. Material according to claim 18 or 19, characterized in that boron carbonitride deposition takes place at a temperature exceeding 700°C.

21. Material according to any one of the claims 18 to 20, characterized in that boron carbonitride deposition takes place at a temperature between 1000 and 1100°C.

22. Material according to any one of the claims 18 to 21, characterized in that the hydrocarbon is acetylene.

**Patentansprüche**

1. Gegen Oxidation geschütztes, kohlenstoffhaltiges Material, das eine Außenbeschichtung aus Borcarbonitrid (4, 8) und mindestens eine äußere Schicht aus Keramik (12), die diese Außenbeschichtung bedeckt, enthält, wobei diese Außenbeschichtung aus einem Mischkristall mit folgenden prozentualen Anteilen an Atomen besteht:

   - von 0 bis 30 % Sauerstoff,
   - von 1 bis 98 % Kohlenstoff,
   - von 1 bis 98 % Bor, und
   - von 1 bis 98 % Stickstoff,

   mit einem atomaren Verhältnis B/N größer oder gleich 1.

2. Material nach Anspruch 1, dadurch gekennzeichnet, daß das Carbonitrid folgende prozentuale Anteile an Atomen enthält:

   - von 0 bis 25 % Sauerstoff,
   - von 5 bis 85 % Kohlenstoff,
   - von 10 bis 50 % Bor, und
   - von 5 bis 50 % Stickstoff.

3. Material nach Anspruch 1, dadurch gekennzeichnet, daß das Borcarbonitrid folgende prozentuale Anteile an Atomen enthält:

   - von 5 bis 25 % Sauerstoff,
   - von 5 bis 80 % Kohlenstoff,

- von 10 bis 50 % Bor, und
- von 5 bis 50 % Stickstoff.

4. Material nach einem der Ansprüche 1 bis 3, dadurch gekennzeichnet, daß das atomare Verhältnis B/N in dem Intervall zwischen 1 und 2 liegt.

5. Material nach Anspruch 1, dadurch gekennzeichnet, daß das Borcarbonitrid folgende prozentuale Anteile an Atomen enthält:

- von 0 bis 25 % Sauerstoff,
- von 9 bis 66 % Kohlenstoff,
- von 22 bis 35 % Bor, und
- von 11 bis 35 % Stickstoff.

6. Material nach Anspruch 1, dadurch gekennzeichnet, daß das Borcarbonitrid folgende Formel aufweist:

$$C_{0,30}B_{0,35}N_{0,35}.$$

7. Material nach Anspruch 1, dadurch gekennzeichnet, daß das Borcarbonitrid folgende Formel aufweist:

$$C_{0,64}B_{0,24}N_{0,12}.$$

8. Material nach Anspruch 1, dadurch gekennzeichnet, daß das Borcarbonitrid der Formel $C_6B_2N$ entspricht.

9. Material nach Anspruch 1, dadurch gekennzeichnet, daß das Borcarbonitrid der Formel $C_5B_2N$ entspricht.

10. Material nach einem der Ansprüche 1 bis 9, dadurch gekennzeichnet, daß die äußere Keramikschicht (12) aus Siliziumnitrid oder -karbid besteht.

11. Material nach einem der Ansprüche 1 bis 10, dadurch gekennzeichnet, daß sich zwischen der Außenbeschichtung (8) und der äußeren Keramikschicht (12) eine Schutz-bzw. Narbenglasschicht (16) befindet.

12. Material nach einem der Ansprüche 1 bis 11, dadurch gekennzeichnet, daß die Außenbeschichtung (8) aus Borkarbonitrid mit einem aus zwei Keramikschichten (18, 20) bestehenden äußeren Belag überzogen ist.

13. Material nach Anspruch 12, dadurch gekennzeichnet, daß der äußere zweischichtige Belag (18, 20) aus einer Barriereschicht aus Nitrid, Karbid, Borid oder Silizid besteht, der durch eine äußere Oxidschicht bedeckt ist.

14. Material nach einem der Ansprüche 1 bis 6, dadurch gekennzeichnet, daß die äußere Keramikschicht (12) aufder Außenbeschichtung aus Borkarbonitrid (8) mit einer Barriereschicht aus Nitrid, Karbid, Borid oder Silizid (18) und darauffolgend mit einer äußeren Oxidschicht (20) überzogen ist.

15. Material nach Anspruch 13 oder 14, dadurch gekennzeichnet, daß die äußere Oxidschicht (20) aus einem Material besteht, das aus den Stoffen Aluminiumoxid, Zirkoniumoxid, Hafniumoxid ($HfO_2$) und einem Spinell vom Typ $Al_2O_3$-$MgO$-$Y_2O_3$ ausgewählt wird.

16. Oxidationsgeschütztes, kohlenstoffhaltiges Verbundmaterial nach einem der Ansprüche 1 bis 15, das ein kohlenstoffhaltiges Substrat enthält, dadurch gekennzeichnet, daß dieses Substart von dem Borkarbonitrid durchsetzt ist.

17. Oxidationsgeschütztes, kohlenstoffhaltiges Verbundmaterial nach einem der Ansprüche 1 bis 15, das ein Substrat aus Kohlenstoffasern (2) enthält, welches in eine kohlenstoffhaltige Matrize eingearbeitet ist (4), dadurch gekennzeichnet, daß die Matrize Borcarbonitrid einschließt.

18. Material nach einem der Ansprüche 1 bis 17, daß die Außenbeschichtung aus Carbonitrid durch eine chemische Ablagerung in der Dampfphase erreicht wird, indem ein Gemisch aus Bortrichlorid, Ammoniak und aus in Wasserstoff verdünntem Kohlenwasserstoff verwendet wird.

19. Material nach Anspruch 18, dadurch gekennzeichnet, daß das Verhältnis zwischen Bortrichlorid und Ammoniak > 1,1 ist.

20. Material nach Anspruch nach Anspruch 18 oder 19, dadurch gekennzeichnet, daß die Ablagerung des Borcarbonitrids bei einer Temperatur über 700 °C erfolgt.

21. Material nach einem der Ansprüche 18 bis 20, dadurch gekennzeichnet, daß die Ablagerung des Borcarbonitrids bei einer Temperatur zwischen 1000°C und 1100°C erfolgt.

22. Material nach einem der Ansprüche 18 bis 21, dadurch gekennzeichnet, daß als Kohlenwasserstoff Azetylen verwendet wird.

20 (Al$_2$O$_3$)

14

18 (AℓN)

16

12 (SiC)

8 (CBN)

4 (CBN)

2 (C)